# EUROPÄISCHE PATENTSCHRIFT

(11) **EP 3 100 058 B1**
(45) Veröffentlichungstag und Bekanntmachung des Hinweises auf die Patenterteilung: **10.07.2019**
(21) Anmeldenummer: 14712640.3
(22) Anmeldetag: 20.03.2014
(51) Int. Cl.: H01R 13/453, H01R 13/627, G01R 11/04, H01R 31/08

(54) **ELEKTRIZITÄTSZÄHLER-ANSCHLUSSSYSTEM UND ÜBERBRÜCKUNGS- SOWIE BLINDSTECKER HIERZU**
ELECTRICITY METER CONNECTION SYSTEM AND BRIDGING AND DUMMY PLUG FOR SAID SYSTEM
SYSTÈME DE RACCORDEMENT DE COMPTEUR ÉLECTRIQUE ET FICHE DE COURT-CIRCUIT AINSI QUE FICHE ISOLANTE

(30) Priorität: 29.01.2014 DE 102014101067
(43) Veröffentlichungstag der Anmeldung: 07.12.2016
(73) Patentinhaber: Wago Verwaltungsgesellschaft mbH, 32423 Minden (DE)
(72) Erfinder: GASSAUER, Stephan, 99768 Ilfeld (DE)
(74) Vertreter: Gerstein, Hans Joachim
(86) Internationale Anmeldenummer: PCT/EP2014/055617
(87) Internationale Veröffentlichungsnummer: WO 2015/113650

(56) Entgegenhaltungen:
- EP-A1- 1 715 351
- DE-A1- 19 613 869
- DE-A1-102011 015 697
- DE-U1- 29 702 870
- DE-U1-202010 006 202
- JP-A- S6 212 868
- JP-A- 2011 095 134
- JP-U- H02 133 667

## Beschreibung

Die Erfindung betrifft ein Elektrizitätszähler-Anschlusssystem mit einem Anschlussklemmenblock, der ein Isolierstoffgehäuse, Leiteranschlüsse zum Anschluss elektrischer Leitungen und Elektrizitätszähler-Anschlussklemmen zur elektrisch leitenden Verbindung von Leiteranschlüssen mit zugeordneten Anschlusskontakten eines an dem Anschlussklemmenblock angeordneten Elektrizitätszählers hat, und mit einem Überbrückungsstecker zum Aufstecken auf den Anschlussklemmenblock, wobei der Überbrückungsstecker Überbrückungskontakte zur elektrisch leitenden Verbindung mit zugeordneten Leiteranschlüssen und Elektrizitätszähler-Anschlussklemmen des Anschlussklemmenblocks hat.

Die Erfindung betrifft weiterhin einen Überbrückungs- sowie einen Blindstecker für ein solches Elektrizitätszähler-Anschlusssystem.

Elektrizitätszähler werden insbesondere in Haushalten zur Messung der verbrauchten elektrischen Energie genutzt. Hierzu werden die Versorgungsleitungen durch ein Leistungsmessgerät hindurchgeschleift und es wird die verbrauchte elektrische Energie gemessen. Zum Anschließen eines Elektrizitätszählers müssen die Energieversorgungsleitungen, d. h. die Phasenleitungen L1, L2, L3 und der Null-Leiter N (Rückleiter) sowie ggf. eine Schutzerde PE mit Leiteranschlussklemmen des Elektrizitätszählers verbunden werden, der Austausch von Elektrizitätszählern gestaltet sich hierdurch sehr umständlich und darf nur durch Fachkräfte durchgeführt werden. Zudem ist die Energieversorgung während des Austauschs unterbrochen.

Eine Verbesserung wird durch Elektrizitätszähler-Anschlussklemmenblöcke erreicht, wie sie beispielsweise aus DE 2 256 373 A, DE 196 13 869 A1 und DE 41 13 328 A1 bekannt sind. Die Anschlussklemmenblöcke haben ein Isolierstoffgehäuse mit Befestigungselementen zur Wandmontage, Leiteranschlüsse zum Anschluss elektrischer Energieversorgungsleitungen und Elektrizitätszähler-Anschlussklemmen zur Aufnahme und Kontaktierung zugeordneter Anschlusskontakte eines Elektrizitätszählers, die als Stiftkontakte zur Verbindung mit Federbügelkontakten ausgeführt sind.

DE 10 2011 015 697 A1 offenbart einen Zählerschaltblock mit mindestens zwei Zählerschaltkontakten je Phase für einen Anschluss an den Elektrizitätszähler, der mindestens zwei Kontaktstücke je Phase hat. Der Zählerschaltblock umfasst ein Schaltelement, mit dem die Zählerschaltkontakte zwischen einer Betriebsposition und einer Entnahmeposition hin- und hergeschaltet werden können. Weiterhin ist eine Überbrückungsvorrichtung für einen solchen Zählerschaltkontakt vorgesehen, um für den Austausch des Elektrizitätszählers die zugeordneten Versorgungsleitungen zu überbrücken und eine weitere Energieversorgung während des Austauschs sicherzustellen. Beim Einführen der Überbrückungsvorrichtung werden die Elektrizitätszähler-Anschlussklemmen geöffnet, um das Entnehmen oder das Anschließen eines Elektrizitätszählers unter Schonung der Elektrizitätszähler-Anschlussklemmen zu erleichtern.

JP H02 133667 U zeigt ein System aus einem Elektrizitätszähler, einem Anschlussklemmenblock, sowie einem Überbrückungsstecker. Hierbei kann der Überbrückungsstecker auf den Anschlussklemmenblock gesteckt werden. Der Überbrückungsstecker weist hierbei laschenartige Streifen auf, mittels welchen der Überbrückungsstecker an dem Anschlussklemmenblock befestigbar ist.

JP 2011 095134 A zeigt ein Überbrückungswerkzeug, welches auf einen Anschlussklemmenblock zum Anschließen eines Elektrizitätszählers zum Überbrücken von Kontakten aufsteckbar ist. Das Überbrückungswerkzeug weist weiterhin Bügel auf, welche über Vorsprünge des Anschlussklemmenblocks legbar sind, sodass das Überbrückungswerkzeug mittels der Bügel an dem Anschlussklemmenblock fixierbar ist.

DE 20 2010 006 202 U1 zeigt ein System aus einer Befestigungs- und Kontaktiereinrichtung und einem zugehörigen Elektrizitätszähler. Ein zugehöriger Überbrückungsstecker ist hierbei auf den Anschlussklemmenblock aufsteckbar, um hieran Anschlüsse zu überbrücken, wobei der Überbrückungsstecker mit Schrauben an dem Anschlussklemmenblock fixierbar ist.

EP 1 715 351 A1 betrifft eine Stromzähleranordnung mit einem Adapter, auf welchen ein Stromzähler aufsetzbar ist. Der Adapter ist hierbei mittels einer Sperrplatte sperrbar, welche eine Unterseite aufweist, die der Unterseite des Stromzählers gleicht.

Die herkömmlichen Überbrückungsvorrichtungen bzw. Überbrückungsstecker sind so ausgebildet, dass sie einfach auf einen Anschlussklemmenblock aufgesteckt und wieder abgezogen werden können.

Ausgehend hiervon ist es Aufgabe der vorliegenden Erfindung, ein verbessertes Elektrizitätszähler-Anschlussklemmensystem sowie einen entsprechend verbesserten Überbrückungsstecker zu schaffen, mit dem ein noch sicherer Austausch eines Elektrizitätszählers ermöglicht wird und ein elektrischer Energieanschluss bestmöglich vor Missbrauch geschützt ist.

Die Aufgabe wird durch das Elektrizitätszähler-Anschlusssystem mit den Merkmalen des Anspruchs 1, durch den Überbrückungsstecker mit den Merkmalen des Anspruchs 15 sowie den Blindstecker mit den Merkmalen des Anspruchs 20 gelöst. Vorteilhafte Ausführungsformen sind in den Unteransprüchen beschrieben.

Es wird vorgeschlagen, dass der Überbrückungsstecker mindestens ein Verriegelungselement hat, welches eine zur Verriegelung an den Anschlussklemmenblock im auf dem Anschlussklemmenblock aufgesetzten Zustand ausgebildete Verriegelungskontur aufweist. Das Verriegelungselement ist derart angeordnet, dass ein Abschnitt eines auf dem Anschlussklemmenblock aufgesteckten Elektrizitätszählers mit dem Verriegelungselement zum Aufheben oder Verhindern einer Verriegelung des Verriegelungselementes an dem Anschlussklemmenblock zusammenwirkt.

Im Unterschied zu den bisherigen, unabhängig von dem Steckzustand des Elektrizitätszählers auf einen Anschlussklemmenblock aufsteckbaren Überbrückungssteckern hat das mindestens eine zusätzliche Verriegelungselement den Vorteil, dass der Überbrückungsstecker bei abgenommenem Elektrizitätszähler fest mit dem Anschlussklemmenblock verriegelbar ist. Damit wird ein unbeabsichtigtes Abziehen des Überbrückungssteckers während des Austauschs eines Elektrizitätszählers und damit eine unbeabsichtigte Unterbrechung der Energieversorgung des zu versorgenden Gebäudes oder der zu versorgenden Anlage verhindert. Zudem wird die Entstehung von Lichtbögen an den Kontakten des Überbrückungssteckers verhindert, die bei Abziehen des Überbrückungssteckers ohne aufgestecktem Elektrizitätszähler bei anliegender Spannung ansonsten entstehen würden.

Die Verriegelung wird zwangsläufig aufgehoben und das mindestens eine Verriegelungselement zwangsweise entriegelt, wenn ein Energiezähler auf den Anschlussklemmenblock aufgesteckt wird. Hierzu ist das Verriegelungselement räumlich so angeordnet und hat eine derart angepasste Kontur, dass ein Abschnitt eines Elektrizitätszählers beim Aufstecken auf den Anschlussklemmenblock ein Verriegelungselement angreift, um dieses von der Verriegelungsstellung in die Entriegelungsstellung zu verlagern. Im Falle eines bereits aufgesteckten Elektrizitätszählers wird bei einem nachträglichen Aufsetzen des Überbrückungssteckers eine Verriegelung des mindestens einen Verriegelungselementes durch eine solche Kontur verhindert. Insbesondere wird damit ein Schutz vor Berührung elektrisch leitender Teile des Überbrückungssteckers durch ungewolltes Abziehen des Überbrückungssteckers erreicht.

Ein vergleichbarer Effekt kann auch dadurch erzielt werden, dass der Überbrückungsstecker einen federbelasteten Berührungsschutzrahmen hat, der die Überbrückungskontakte umgibt und in Erstreckungsrichtung der Überbrückungskontakte beweglich an einem Isolierstoffmantel des Überbrückungssteckers gelagert ist. Zwischen dem Isolierstoffmantel und dem Berührungsschutzrahmen ist mindestens ein Federelement angeordnet, das die Verlagerung des Berührungsschutzrahmens in einen die aus dem Isolierstoffmantel herausragenden Abschnitte der Überbrückungskontakte mindestens teilweise abdeckenden Zustand bewirkt. Durch einen solchen beweglich am Überbrückungsstecker gelagerten Berührungsschutzrahmen werden somit die aus dem Isolierstoffmantel herausragenden Abschnitte der Überbrückungskontakte mindestens teilweise so weit abgedeckt, dass eine Berührung elektrisch leitender und durch die Verbindung mit dem Anschlussklemmenblock unter Umständen ein gefährliches elektrisches Potential aufweisenden Teile der Überbrückungskontakte weitestgehend ausgeschlossen werden kann.

Besonders vorteilhaft ist es, wenn zwei federelastische oder federelastisch gelagerte Verriegelungshebel diametral gegenüberliegend an dem Überbrückungsstecker angeordnet sind. Die Verriegelungshebel haben dabei jeweils eine Rastkontur zur Verrastung mit einem zugeordneten Anschlussklemmenblock.

Mit Hilfe eines solchen Paares einander gegenüberliegender Verriegelungshebel gelingt es, den Überbrückungsstecker in seiner Hauptachse (d.h., die sich in Anreihrichtung der Überbrückungskontakte des Überbrückungssteckers erstreckende Querachse) am Anschlussklemmenblock festzulegen. Die einander gegenüberliegenden Verriegelungshebel wirken dabei in einer aufeinander zu gerichteten Weise, um den Überbrückungsstecker nicht nur einfach vor herausziehen, sondern auch vor einer ungünstigen Kippbewegung zu sichern. Die Verriegelungshebel können in einer Ausführungsform als schwenkbar an dem Überbrückungsstecker gelagerte, starre Hebelarme ausgeführt sein, wobei jeweils eine vorspringende Rastnase an den freien Enden der Hebelarme angeordnet ist. Zwischen Hebelarm und Überbrückungsstecker befindet sich dann ein Federelement zur federelastischen Verlagerung des Hebelarms in die Verriegelungsposition.

Solche starren Hebelarme sind hinreichend stabil und kompakt ausführbar und mit einem Schwenklager in eine geeignete Vertiefung in einem Isolierstoffmantel einbaubar. Ein solcher Überbrückungsstecker kann damit sehr kompakt und stabil ausgeführt werden.

Denkbar ist auch eine Variante der Verriegelungselemente, die nicht schwenkbar, sondern quer zur Steckrichtung des Überbrückungssteckers (d.h. quer zur Erstreckungsrichtung der Überbrückungskontakte bzw. parallel zur Anreihrichtung der Überbrückungskontakte) verschiebbar gelagert sind.

Besonders vorteilhaft ist es jedoch, wenn die Verriegelungshebel als federelastisch biegsame Blechstreifen mit einer aus der Ebene des Blechstreifens vorspringende Rastlasche am freien Ende ausgebildet sind. Ein solcher Blechstreifen kann aus einem biegsamen Metallblech oder ggf. auch aus einem federelastischen Kunststofffaser- oder Kohlefasermaterial hergestellt werden. Unter einem "Blech" wird ein dünnes blattartiges Material verstanden, dass eine hinreichende Federelastizität bereitstellt und in einem Streifen mit wesentlich größerer Länge als Breite ausgeführt werden kann.

Ein solcher federelastisch biegsamer Blechstreifen ist nicht nur preiswert, sondern kann auch bei geringem Raumbedarf in einen kompakten Überbrückungsstecker integriert werden.

Dabei kann der Blechstreifen in eine Aufnahmenut im Isolierstoffmantel des Überbrückungsstecker so eingebaut werden, dass der Blechstreifen zumindest im Zustand, bei dem der Überbrückungsstecker auf dem Anschlussklemmenblock aufgesteckt ist, nicht von Außen zugänglich ist. Die hierdurch bewirkte Verriegelung kann somit nur durch das Aufstecken eines Elektrizitätszählers aufgehoben werden, der den Blechstreifen aus der Verriegelungsposition in die Entriegelungsposition verlagert. Damit wird eine manipulationssichere Verriegelung des Überwachungssteckers am Anschlussklemmenblock erreicht.

Besonders vorteilhaft ist es, wenn die Rastnasen oder Rastlaschen der Verriegelungshebel einstückig aus dem Verriegelungshebel ausgebildet sind. Dabei kann z. B. eine Rastlasche aus dem Blechstreifen freigelegt (freigestanzt, freigeschnitten o. ä.) und dann aus der Ebene des Blechstreifens herausgebogen sein.

Die Rastkonturen und/oder der Elektrizitätszähler haben in einer besonders vorteilhaften Ausführungsform eine schräge Führungsfläche, die ausgerichtet ist, um eine Verlagerung des zugeordneten Verriegelungshebels aus einer Verriegelungsposition in eine Entriegelungsposition bei Aufstecken eines Elektrizitätszählers auf den Anschlussklemmenblock zu bewirken.

Mit Hilfe solcher schrägen Führungsflächen wird erreicht, dass die Verriegelungshebel beim Aufstecken des Elektrizitätszählers durch eine quer zur Ersteckungsrichtung des Verriegelungshebels wirkende Kraft aus der Verriegelungsposition in die Entriegelungsposition verschwenkt wird. Die Kraftrichtung wird durch die schräge Führungsfläche vorgegeben und durch die schräge Führungsfläche wird verhindert, dass der Elektrizitätszähler einfach auf dem Verriegelungshebel aufstößt.

In einer besonders vorteilhaften Ausführungsform ist der Berührungsschutzrahmen in einer Ausnehmung des Isolierstoffmantels des Überbrückungssteckers beweglich gelagert. Damit taucht der Berührungsschutzrahmen im Zustand, bei der der Überbrückungsstecker auf dem Anschlussklemmenblock aufgesteckt ist, mindestens teilweise in den Isolierstoffmantel ein. Damit kann der Überbrückungsstecker sehr kompakt und robust ausgebildet werden.

Besonders vorteilhaft ist es, wenn die Überbrückungskontakte U-förmig gebogen sind und zwei über einen gemeinsamen Bogenabschnitt miteinander verbundene, parallele Steckkontaktabschnitte haben. Die Steckkontaktabschnitte ragen dabei aus dem Isolierstoffmantel heraus. Mit Hilfe solcher U-förmig gebogener Überbrückungskontakte gelingt es, diese äußert stabil in einen besonders kompakten Überbrückungsstecker einzubauen. Der Bogenabschnitt ist hierzu in dem Isolierstoffmantel festgelegt. Bei dieser Ausführungsform ist das mindestens eine zwischen Isolierstoffmantel und Berührungsschutzrahmen angeordnete Federelement in einem durch einen Bogenabschnitt begrenzten Innenraum gelagert. Das Federelement stützt sich damit in dem Isolierstoffmantel in einem durch den Bogenabschnitt umgebenen Bereich ab. Hierdurch wird eine äußert kompakte Ausführungsform und Anordnung des Federelementes bei einem guten Kraftfluss erreicht. Die durch das Auflagern des Federelementes auf den Isolierstoffmantel ausgeübte Federkraft wird nämlich nicht nur durch den Isolierstoffmantel, sondern durch den sich daran angrenzenden Bogenabschnitt aufgenommen.

Vorzugsweise sind zwei diametral gegenüberliegende Federelemente vorgesehen, die jeweils im Innenraum der Bogenabschnitte der äußeren Überbrückungskontakte angeordnet sind. Auf diese Weise kann der Berührungsschutzrahmen beidseits gleichmäßig federelastisch am Isolierstoffmantel gelagert werden. Diese Ausführungsform wirkt der Gefahr einer Verkantung des Berührungsschutzrahmens entgegen.

Besonders vorteilhaft ist es, wenn das Elektrizitäts-Anschlusssystem einen Blindstecker umfasst. Dieser Blindstecker ist an Stelle eines Energiezählers zum Aufstecken auf den Anschlussklemmenblock vorgesehen. Er hat mindestens einen vorzugsweise in Form von diametral gegenüberliegenden Führungszapfen ausgebildeten Abschnitt, der ausgebildet ist, um im aufgesteckten Zustand des Blindsteckers auf den Anschlussklemmenblock mit dem Verriegelungselement zum Aufheben oder Verhindern einer Verriegelung des Verriegelungselementes an dem Anschlussklemmenblock zusammenzuwirken. Damit wird bei aufgesetztem Blindstecker genau so wie bei aufgesetztem Elektrizitätszähler eine zwangsweise Entriegelung des Überbrückungssteckers bewirkt. In dieser Hinsicht hat der Blindstecker somit eine mit dem Energiezähler vergleichbare Kontur, so dass es sich bei dem Blindstecker quasi um einen nicht funktionsfähigen "Dummy"-Energiezähler handelt.

Mit einem solchen Blindstecker gelingt das manipulationssichere Verschließen der Elektriziätszähler-Anschlussklemmen am Anschlussklemmenblock, wenn der Energiezähler z.B. aufgrund unbezahlter Stromrechung entfernt und das Gebäude durch Entnehmen des Überbrückungssteckers von der Energieversorgung abgekoppelt werden soll.

Vorzugsweise hat der Blindstecker Führungselemente, die korrespondierend mit Anschlusskontakten des Elektrizitätszählers zur Einführung in zu Elektrizitätszähler-Anschlussklemmen führende Einführungsöffnungen des Anschlussklemmenblocks ausgebildet sind. Diese Führungselemente sind untereinander nicht verbunden und haben keine elektrische Funktion. Sie dienen zur verbesserten Führung des Blindsteckers beim Aufstecken auf den Anschlussklemmenblock und verbessern den stabilen, manipulationssicheren Sitz des Blindsteckers auf dem Anschlussklemmenblock.

Besonders vorteilhaft ist es dabei, wenn mindestens eines der Führungselemente eine Rastkontur zur Verrastung des Blindsteckers an dem Anschlussklemmenblock hat. Mit Hilfe einer solchen Rastkontur können die Führungselemente - genau so wie entsprechende mit Rastkonturen versehene Anschlusskontakte eines Elektrizitätszählers - beim Aufstecken und Anklemmen an den Anschlussklemmenblock z.B. mit Hilfe der in die Rastkonturen eingreifenden Elektrizitätszähler-Anschlussklemmen verrastet werden. Solche Rastkonturen sind besonders vorteilhaft an den Führungselementen vorhanden, die mit den Elektrizitätszähler-Anschlussklemmen für den Neutralleiter und/oder Masseanschluss zusammenwirken. Dies sind bevorzugt die beiden sich diametral gegenüberliegenden äußeren Führungselemente, so dass eine gegen Heraushebeln optimal wirkende Verriegelung erreicht wird.

Die Erfindung wird nachfolgend anhand von Ausführungsbeispielen mit den beigefügten Zeichnungen näher erläutert. Es zeigen:
- Figur 1: - Perspektivische Ansicht einer ersten Ausführungsform eines Elektrizitätszähler-Anschlusssystems;
- Figur 2: - Draufsicht auf das Elektrizitätszähler-Anschlusssystem aus Figur 1;
- Figur 3: - Perspektivische Ansicht des Elektrizitätszähler-Anschlusssystem aus Figuren 1 und 2 von vorne;
- Figur 4: - Perspektivische Ansicht des Elektrizitätszähler-Anschlusssystems mit aufgestecktem Überbrückungsstecker im Entriegelungszustand;
- Figur 5: - Perspektivische Ansicht des Elektrizitätszähler-Anschlusssystems aus Figur 4 im Verriegelungszustand ohne aufgesteckten Elektrizitätszähler;
- Figur 6: - Ausschnittsansicht im Bereich einer Verriegelung des Elektrizitätszähler-Anschlusssystems aus Figur 4 im entriegelten Zustand;
- Figur 7: - Ausschnittsansicht der Verriegelung des Überbrückungssteckers gemäß Figur 5;
- Figur 8: - Perspektivische Ausschnittsansicht im Verriegelungszustand gemäß Figur 7;
- Figur 9: - Perspektivische Ausschnittsansicht im Entriegelungszustand gemäß Figur 6;
- Figur 10: - Perspektivische Schnittansicht einer ersten Ausführungsform eines Überbrückungssteckers mit federbelasteten schwenkbaren Verriegelungshebeln und einem Berührungsschutzrahmen im Schutzzustand;
- Figur 11: - Schnittansicht des Überbrückungssteckers aus Figur 10 mit einem Berührungsschutzrahmen im ungeschützten Zustand sowie ausgelenkten Verriegelungshebeln;
- Figur 12: - Schnittansicht einer zweiten Ausführungsform eines Überbrückungssteckers mit federelastischen Blechstreifen als Verriegelungshebel und mit einem Berührungsschutzrahmen im Schutzzustand;
- Figur 13: - Schnittansicht des Überbrückungssteckers aus Figur 12 mit einem Berührungsschutzrahmen im ungeschützten Zustand sowie ausgelenkten Blechstreifen;
- Figur 14: - perspektivische Ansicht eines federelastischen Blechstreifens für den Überbrückungsstecker aus Figuren 12 und 13;
- Figur 15: - Perspektivischer Ansicht einer ersten Ausführungsform eines Blindsteckers;
- Figur 16: - Perspektivischer Ansicht einer zweiten Ausführungsform eines Blindsteckers mit längeren und kürzeren Führungselementen;
- Figur 17: - Seiten-Schnittansicht des Blindsteckers aus Figur 16.

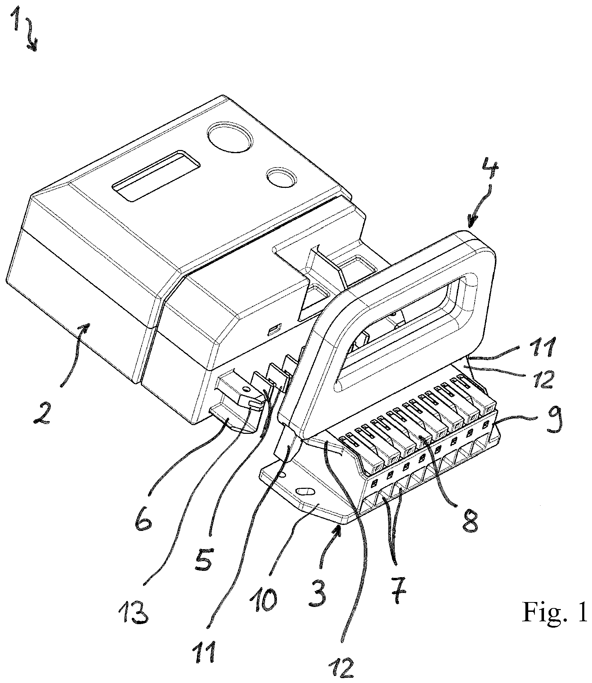

Figur 1 lässt eine perspektivische Ansicht eines Elektrizitätszähler-Anschlusssystems 1 mit einem Elektrizitätszähler 2, einem Anschlussklemmenblock 3 und einem Überbrückungsstecker 4 erkennen. Der Elektrizitätszähler 2 hat in an sich bekannter Weise eine Leistungsmesseinheit zur Erfassung der von einem Verbraucher genutzten elektrischen Leistung über die Zeit. Der Elektrizitätszähler 2 ist steckbar ausgeführt und hat Anschlusskontakte 5 in Form von Steckkontakten zum Einstecken in den Anschlussklemmenblock 3 und zur elektrisch leitenden Verbindung zugeordneter Steckkontakte im Anschlussklemmenblock 3. Das lagerichtige Aufsetzen des Elektrizitätszählers 2 auf den Anschlussklemmenblock 3 wird durch zwei diametral einander gegenüberliegenden Führungszapfen 6 erreicht, die von dem Gehäuse des Elektrizitätszählers 2 parallel zu den Anschlusskontakten 5 in Steckrichtung herausragen.

Der Anschlussklemmenblock 3 hat eine Anzahl von Leiteranschlüssen mit zugeordneten Leitereinführungsöffnungen 7 und Betätigungshebeln 8. Die Betätigungshebel 8 sind bei der Ausführungsform der Leiteranschlüsse als Federkraftanschlüsse vorgesehen, um die Klemmfedern der Leiteranschlüsse zu öffnen und das Einführungen bzw. Entnehmen eines in eine Leitereinführungsöffnung 7 eingeführten elektrischen Leiters zu ermöglichen.

Der Leiteranschlussklemmenblock 3 hat ein Isolierstoffgehäuse 9, von dem seitlich diametral gegenüberliegend Befestigungsflansche 10 abragen. Mit Hilfe dieser Befestigungsflansche 10 kann der Anschlussklemmenblock 3 z. B. auf einer Montagefläche, wie z. B. einer Wand befestigt werden.

Weiterhin ist ein Überbrückungsstecker 4 vorhanden, der auf den Anschlussklemmenblock 3 aufgesetzt und mit nicht sichtbaren Überbrückungskontakten elektrisch leitend mit Leiteranschlüssen und Elektrizitätszähler-Anschlussklemmen des Anschlussklemmenblocks 3 verbunden werden kann. Auf diese Weise lässt sich eine weitere Versorgung eines Gebäudes oder einer Anlage auch bei abgezogenem Elektrizitätszähler 2 erreichen, indem die ansonsten durch den Elektrizitätszähler 2 geführten Verbindungen der einzelnen Phasenleitungen jeweils überbrückt werden.

Mit Hilfe des Überbrückungssteckers 4 werden somit die von einer Versorgungsleitung ankommenden Phasen jeweils elektrisch leitend mit den zugeordneten, in ein Gebäude geführten Leitungen verbunden.

Erkennbar ist, dass der Überbrückungsstecker 4 an seinen diametral gegenüberliegenden, im aufgesteckten Zustand dem Anschlussklemmenblock 3 zugewandten Seiten jeweils ein Verriegelungselement 11 hat, das den Überbrückungsstecker 4 im dargestellten auf dem Anschlussklemmenblock 3 aufgesetzten Zustand mit einer Verriegelungslasche 12 des Anschlussklemmenblocks 3 verriegelt. Hierzu untergreift eine nicht sichtbare Rastnase der Verriegelungselemente 11 die zugeordnete Verriegelungslasche 12.

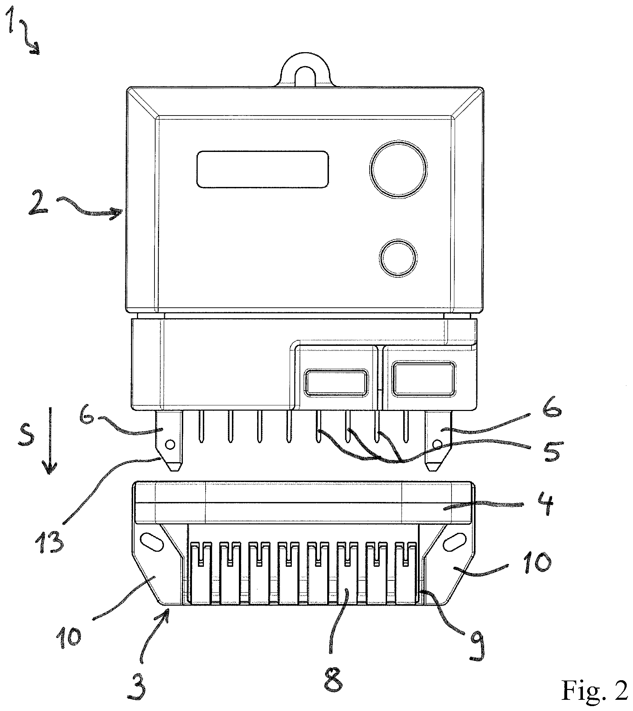

Figur 2 lässt eine Draufsicht auf das Elektrizitätszähler-Anschlusssystem 1 aus Figur 1 erkennen. Deutlich wird, dass von dem Elektrizitätszähler 2 in Steckrichtung S eine Anzahl von Anschlusskontakten 5 abragen. Angrenzend an die beiden äußeren Anschlusskontakte 5 der Reihe von Anschlusskontakten 5 ist jeweils ein Führungszapfen 6 mit einer schrägen Führungsfläche 13 am freien Endbereich vorgesehen, der jeweils in einen zugeordneten Freiraum im Anschlussklemmenblock 3 beim Aufstecken des Elektrizitätszählers 2 auf einen Anschlussklemmenblock 3 eintaucht. Dieser Freiraum wird durch die Befestigungsflansche 10 und die im Abstand davon sich parallel hierzu erstreckenden Verriegelungslaschen 12 sowie durch die Seitenwände des Isolierstoffgehäuses 9 des Anschlussklemmenblocks 3 begrenzt.

Der Anschlussklemmenblock 3 hat an der dem Elektrizitätszähler 2 zugewandten Stirnseite Einführungsöffnungen zum Einführen der Anschlusskontakte 5 in das Isolierstoffgehäuse 9 des Anschlussklemmenblocks, die zu Elektrizitätszähler-Anschlussklemmen (nicht sichtbar) im Innenraum des Isolierstoffgehäuses 9 führen. Für jede Anschlussklemme 5 ist im Anschlussklemmenblock 3 ein mit einer zugeordneten Elektrizitätszähler-Anschlussklemme elektrisch leitend verbundener Leiteranschluss vorhanden, der jeweils einer Leitereinführungsöffnung 7 auf der gegenüberliegenden Stirnseite (vgl. Figur 1) zugeordnet ist. Auf diese Weise kann jeweils ein in eine Leitereinführungsöffnung 7 eingeführter elektrischer Leiter mit Hilfe des zugeordneten Leiteranschlusses und der damit verbundenen Elektrizitätszähler-Anschlussklemme elektrisch leitend mit genau einer Anschlussklemme 5 des Elektrizitätszählers 2 verbunden werden.

Quer zur Steckrichtung S lässt sich ein Überbrückungsstecker 4 auf den Anschlussklemmenblock 3 aufstecken, um zugeordnete Leiteranschlüsse bzw. die entsprechenden Paare von eingehenden und abgehenden Leitungen elektrisch leitend miteinander zu verbinden. Vorzugsweise bilden immer ein Paar von nebeneinander angeordneten Leiteranschlüssen bzw. Elektrizitätszähler-Anschlussklemmen im Anschlussklemmenblock 3 ein Anschlusspaar für eine eingehende und eine zugehörige abgehende Leitung. Diese Anschlusspaare können nun durch den Überbrückungsstecker 4 überbrückt werden, um eine weitere elektrische Versorgung des angeschlossenen Gebäudes oder der Anlage auch bei abgezogenem Elektrizitätszähler 2 sicherzustellen.

Optional ist denkbar, dass der Überbrückungsstecker 4 eine verschiebbar oder verschwenkbar am Überbrückungsstecker 4 gelagerte Abdeckplatte (nicht dargestellt) hat, um im Zustand, bei dem der Überbrückungsstecker 4 auf den Anschlussklemmenblock 3 aufgesteckt und der Elektrizitätszähler 2 vom Anschlussklemmenblock 3 abgezogen ist, die zu den Elektrizitätszähler-Anschlussklemmen führenden Einführöffnungen des Anschlussklemmenblocks 3 abzudecken. Damit wird das Elektrizitätszähler-Anschlusssystem 1 einerseits vor Manipulation geschützt und es wird die Gefahr eines Stromschlags bei unbefugtem Einführen elektrisch leitender Gegenstände in die ansonsten freien Einführöffnungen unterbunden.

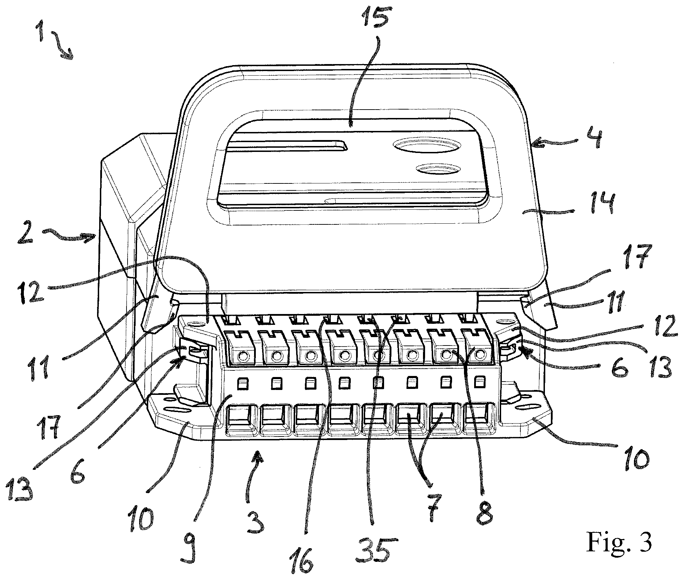

Figur 3 lässt das Elektrizitätszähler-Anschlusssystem 1 aus den Figuren 1 und 2 in dem Zustand der erkennen, in dem der Elektrizitätszähler 2 auf den Anschlussklemmenblock 3 aufgesteckt ist und der Überbrückungsstecker 4 ebenfalls aus den Anschlussklemmenblock 3 aufgesetzt wird. Deutlich wird, dass der Überbrückungsstecker 4 einen griffartig ausgebildeten Isolierstoffmantel 14 mit einer zentralen Griffmulde 15 hat. Aus dem Isolierstoffmantel 14 ragen eine Anzahl nebeneinander angeordneter Überbrückungskontakte 35 hervor. Die Teilung der Überbrückungskontakte 35 entspricht in diesem Ausführungsbeispiel der Teilung (dem Abstand) der nebeneinander angeordneten Leitereinführungsöffnungen 7 und der daran angeordneten Leiteranschlüsse und Elektrizitätszähler-Anschlussklemmen im Anschlussklemmenblock 3. Die Überbrückungskontakte 35 sind in Überbrückungsöffnungen 16 an der Oberseite des Isolierstoffgehäuses 9 des Anschlussklemmenblocks 3 einführbar und in aufgestecktem Zustand elektrisch leitend mit jeweils einem zugeordneten Leiteranschluss und einer zugeordneten Elektrizitätszähler-Anschlussklemme des Anschlussklemmenblocks 3 verbunden. Erkennbar ist weiterhin, dass aus dem Isolierstoffmantel 14 zwei diametral sich gegenüberliegende Verriegelungselemente 11 in Form von Verriegelungshebeln herausragen. Diese Verriegelungselement 11 haben an ihrem freie Ende jeweils eine Rastnase 17 zum Untergreifen einer zugeordneten Verriegelungslasche 12. Deutlich wird, dass in dem dargestellten Zustand, bei dem der Elektrizitätszähler 2 auf den Anschlussklemmenblock 3 aufgesetzt wird, die Führungszapfen 6 des Elektrizitätszählers 2 in einen Freiraum derart eintauchen, dass ein Teil der Führungszapfen 6 an eine zugeordnete Verriegelungslasche 12 angrenzt. Auf diese Weise wird verhindert, dass die Rastnase 17 des Verriegelungselementes 11 die Verriegelungslasche 12 untergreift und der Überbrückungsstecker 4 damit an dem Anschlussklemmenblock 3 verrasten kann. Vielmehr bildet der Führungszapfen 6 einen Anschlag für ein zugeordnetes Verriegelungselement 11 und treibt dieses federelastisch gelagerte Verriegelungselement 11 aus der Verriegelungsposition in die dargestellte Entriegelungsposition.

Entsprechend wird durch schräge Führungsflächen 13 der Führungszapfen 6 erreicht, dass in dem Zustand, bei dem ein Überbrückungsstecker 4 auf einen Anschlussklemmenblock 3 aufgesetzt und dort verriegelt wird, die Verriegelungselemente 11 beim Aufstecken eines Elektrizitätszählers 2 durch Krafteinwirkung der konischen Schrägfläche 13 der Führungszapfen 6 auf eine zugeordnete Rastnase 17 die Verriegelungselemente 11 aus der Verriegelungsposition in die dargestellte Entriegelungsposition gebracht werden.

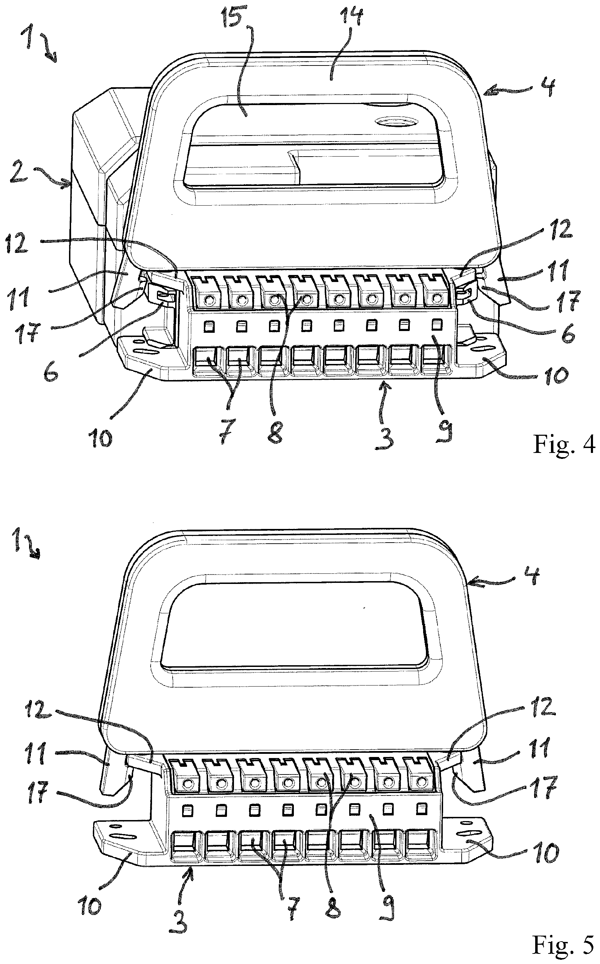

Figur 4 zeigt den Zustand, in dem sowohl der Überbrückungsstecker 4 als auch der Elektrizitätszähler 2 auf den Anschlussklemmenblock 3 aufgesteckt ist. Deutlich wird, dass die Verriegelungselemente 11 aufgrund der Führungszapfen 6 des Elektrizitätszählers 2 in der Entriegelungsposition verbleiben. Der Überbrückungsstecker 4 kann damit leicht abgezogen werden und ist nicht am Anschlussklemmenblock 3 gesichert.

Figur 5 zeigt hingegen eine perspektivische Ansicht des Elektrizitätszähler-Anschlusssystems 1 ohne aufgesteckten Elektrizitätszähler 2. Deutlich wird, dass nunmehr der Zwischenraum zwischen den Verriegelungslaschen 12 und den gegenüberliegenden Befestigungslaschen 10 frei ist. Damit kann die Rastnase 17 der Verriegelungselemente 11 jeweils eine zugeordnete Verriegelungslasche 12 untergreifen. Damit wird der Überbrückungsstecker 4 durch die diametral einander gegenüberliegenden Verriegelungselemente 11 an dem Anschlussklemmenblock 3 verriegelt. Ein unbeabsichtigtes Abziehen des Überbrückungssteckers 4 wird somit verhindert und es wird zwangsläufig sichergestellt, dass ein an den Anschlussklemmenblock 3 angeschlossenes Gebäude oder eine Anlage weiterhin trotz abgezogenem Elektrizitätszähler 2 mit elektrischer Energie versorgt wird.

Der innere Aufbau der Anschlussklemmenblöcke 3 mit seinen Leiteranschlüssen und Elektrizitätszähler-Anschlussklemmen ist an sich bekannt und bedarf keiner weiteren Beschreibung.

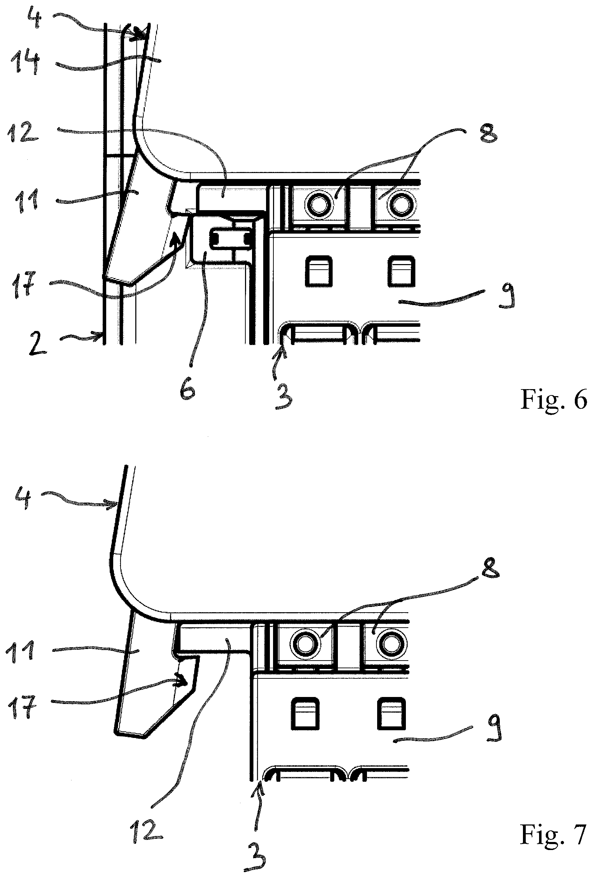

Figur 6 lässt eine Ausschnittsansicht des Elektrizitätszähler-Anschlusssystems 1 gemäß Figur 4 im Bereich eines Verriegelungselementes 11 erkennen. Deutlich wird, dass die Rastnase 17 des Verriegelungselementes 11 auf der zugeordneten Führungskontur 6 des aufgesteckten Energiezählers 2 aufliegt und durch die Führungskontur 6 in einer Entriegelungsposition gehalten wird. Der Überbrückungsstecker 4 lässt sich somit einfach von dem Anschlussklemmenblock 3 abziehen.

Figur 7 lässt das Elektrizitätszähler-Anschlusssystem 1 gemäß Figur 5 in der Ausschnittsansicht im Bereich eines Verriegelungselementes 11 erkennen. Dabei ist der Energiezähler 2 von dem Anschlussklemmenblock 3 abgezogen. Deutlich wird, dass hierdurch der Raum direkt unterhalb der Verriegelungslasche 12 frei wird und die Verriegelungsnase 17 des Verriegelungselementes 11 nunmehr die Verriegelungslasche 12 untergreifen kann. Das Verriegelungselement 11 ist damit in die Verriegelungsposition verschwenkt, um den Überbrückungsstecker 4 mit Hilfe der die Verriegelungslasche 12 untergreifenden Rastnase 17 zu Verriegeln und vor Abziehen vom Anschlussklemmenblock 3 zu sichern.

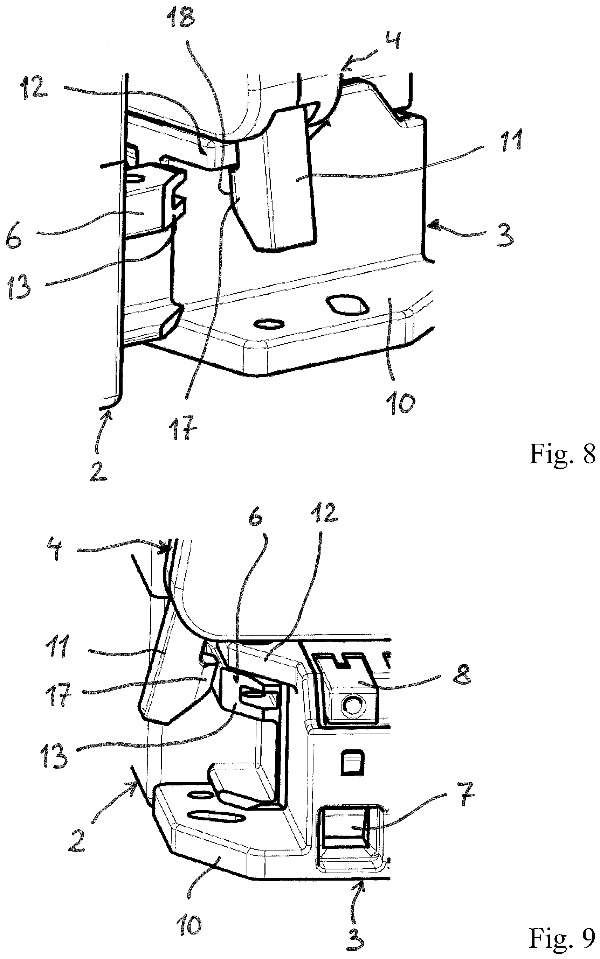

Figur 8 lässt eine entsprechende perspektivische Ausschnittsansicht erkennen, bei der der Überbrückungsstecker 4 in der Verriegelungsposition gemäß Figur 7 ist. Dabei wird deutlich, dass die Rastnase 17 eine sich quer zur Schwenkrichtung ausgerichtete schräge Führungsfläche 18 hat, die mit der schrägen Führungsfläche der Führungskontur 6 des Elektrizitätszählers 2 zusammenwirkt, wenn der Führungszapfen 6 auf die Rastnase 17 beim Aufstecken des Elektrizitätszählers 2 aufstößt. Auf diese Weise wird bei Aufstecken des Elektrizitätszählers 2 auf den Anschlussklemmenblock 3 erreicht, dass das Verriegelungselement 11 aus der dargestellten Verriegelungsposition in die Entriegel-ungsposition verschwenkt wird.

Dieser Zustand mit dem in Entriegelungsposition verschwenkten Verriegelungselement 11 ist in der Figur 9 in perspektivischer Ansicht gezeigt.

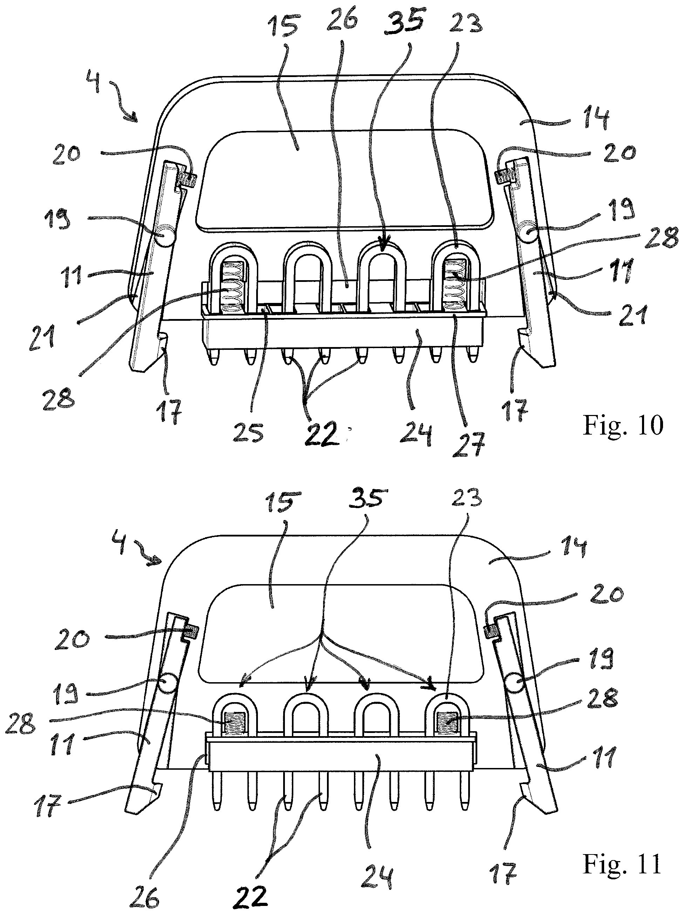

Figur 10 lässt eine Schnittansicht einer ersten Ausführungsform eines Überbrückungssteckers 4 erkennen. Deutlich wird, dass in dem Isolierstoffmantel diametral gegenüberliegend zwei Verriegelungselemente 11 in Form von Verriegelungshebeln um eine Schwenkachse 19 jeweils schwenkbar gelagert sind. Die Verriegelungselemente 11 haben an ihrem freien Ende jeweils eine Rastnase 17. Die Verriegelungselemente 11 (Verriegelungshebel) sind an der Seite, die der Rastnase 17 gegenüberliegt, durch ein Federelement 20 in Form einer Druckfeder federelastisch gelagert. Das Federelement 20 übt dabei eine Federkraft auf das zugeordnete Verriegelungselement 11 aus, die dieses wie dargestellt in die Verriegelungsposition bringt. Die Verriegelungselemente 11 sind hierbei in einer geeigneten konturierten Ausnehmung 21 des Isolierstoffmantels 14 gelagert, die das Verschwenken der Verriegelungselemente 11 in der dargestellten Verriegelungsposition in eine Entriegelungsposition um die Schwenkachse 19 erlaubt. Hierzu verläuft die Ausnehmung 21 beidseits konisch verjüngend zum Schwenklager 19 hin. Deutlich wird weiterhin, dass U-förmig gebogene Überbrückungskontakte 35 in dem Isolierstoffmantel 14 an der Aufsteckseite 14 eingebaut sind, an welcher sich Rastnasen 17 befinden. Ein Überbrückungskontakt 35 hat dabei jeweils ein Paar parallel zu einander aus dem Isolierstoffmantel 14 herausragende Steckkontaktabschnitte 22 in Form von Steckkontaktstiften. Auf diese Weise werden in diesem Ausführungsbeispiel vier Paare von Steckkontaktabschnitten 22 bereitgestellt und es können vier Leitungspaare elektrisch leitend überbrückt werden. Somit können die drei Phasen und der Nullleiter eines dreiphasigen Hausanschlusses mit den Überbrückungskontakten 35 überbrückt werden.

Deutlich wird, dass die Steckkontaktabschnitte 22 eines U-förmig gebogenen Überbrückungskontaktes 35 mit Hilfe eines gemeinsamen Bogenabschnittes 23 miteinander verbunden sind.

Erkennbar ist weiterhin, dass die Überbrückungskontakte 35 und insbesondere deren Steckkontaktabschnitte 22 von einem Berührungsschutzrahmen 24 umgeben sind. Der Berührungsschutzrahmen 24 ist rechteckförmig und hat eine Anzahl von Führungsöffnungen 25, durch die jeweils ein zugeordneter Steckkontaktabschnitt 22 hindurchgeführt wird. Der Berührungsschutzrahmen 24 ist in Aufsteckrichtung A beweglich in einer Ausnehmung 26 des Isolierstoffmantels 14 gelagert und in der Ausnehmung 26 mit Hilfe eines vorspringenden Randsteges 27 vor Herausgleiten aus der Ausnehmung 26 und damit aus dem Isolierstoffmantel 14 heraus gesichert. Hierzu ist die Ausnehmung 26 mit geeigneten Vorsprüngen versehen, die einen Anschlag für den Randsteg 27 bilden. Erkennbar ist weiterhin, dass an den beiden äußeren Überbrückungskontakten 35 jeweils einander diametral gegenüberliegende Federelemente 28 vorhanden sind. Diese sind mit einem freien Ende in einem durch die äußeren U-förmig gebogenen Überbrückungskontakte 35 begrenzten Innenraum angeordnet. Das gegenüberliegende freie Ende liegt auf dem Berührungsschutzrahmen 24 auf. Auf diese Weise wird sichergestellt, dass der Berührungsschutzrahmen 24 unter reduzierter Gefahr des Verkippens beweglich in der Ausnehmung 26 gehalten und durch die Federkraft der Federelemente 28 in die dargestellte Schutzposition gedrückt wird.

Zur Lagerung der Federelemente 28 ist in dem durch die Bogenabschnitte 23 und die sich daran anschließenden Steckkontaktabschnitte 22 begrenzten Innenraum ein Freiraum im Isolierstoffmantel 14 geschaffen, so dass sich die Federelemente 28 am Isolierstoffmantel abstützen, der seinerseits jeweils an einen Bogenabschnitt 23 angrenzt.

Figur 11 lässt die Darstellung der Ausführungsform des Überbrückungsstecker 4 aus Figur 10 in der Aufsteckposition erkennen, bei dem das Berührungsschutzelement 24 in die Ausnehmung 26 hinein verlagert ist. Auf diese Weise werden die Steckkontaktabschnitte 22 freigegeben und können in die zugeordneten Einstecköffnungen 16 des Anschlussklemmenblocks 3 eintauchen. Damit ist der Berührungsschutz der Steckkontaktabschnitte 15 aufgehoben. Die Verlagerung des Berührungsschutzabschnittes 24 erfolgt entgegen der Kraft der Federelemente 28, die komprimiert werden. Damit wird eine Federkraft auf den Berührungsschutzrahmen 24 ausgeübt, der an sich eine Verlagerung des Berührungsschutzrahmens 24 in die Schutzposition gemäß Figur 10 bewirkt.

Erkennbar ist weiterhin, dass die Verriegelungselemente 11 (Verriegelungshebel) in die Entriegelungsposition geschwenkt sind. Dabei wird das jeweilige der Rastnase 17 gegenüberliegende Federelement 20 komprimiert und durch das Federelement 20 wird eine Federkraft auf das Verriegelungselement 20 ausgeübt. Mit Hilfe des Federelementes 20 wird somit erreicht, dass das Verriegelungselement 11 in den Verriegelungszustand gemäß Figur 10 zurück geschwenkt wird. Die Verriegelungselemente 11 sind somit durch die Federelemente 20 federbelastet.

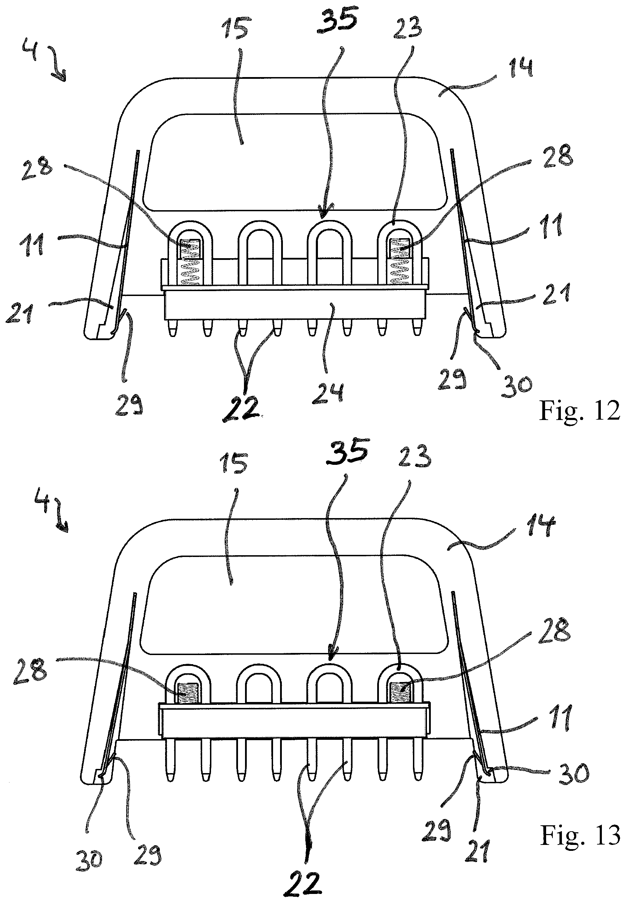

Figur 12 lässt eine zweite Ausführungsform eines Überbrückungsstecker 4 erkennen. Dabei ist die Ausführungsform des Berührungsschutzelementes 24 und der Überbrückungskontakte 35 vergleichbar mit der ersten Ausführungsform, so dass auf das dort Gesagte verwiesen wird.

Im Unterschied zur ersten Ausführungsform sind die Verriegelungselemente 11 nunmehr als federelastische Blechstreifen ausgeführt, die an ihrem freien Ende eine integral mit dem Blechstreifen geformte und aus der Ebene des Blechstreifens herausgestellte Rastlasche 29 haben. Die Verriegelungselemente 11 sind wiederum in einer jeweils zugeordneten Ausnehmung 21 angeordnet, die eine Verlagerung des Verriegelungselementes 11 aus der dargestellten Verriegelungsposition in eine Entriegelungsposition ermöglicht. Deutlich wird, dass das Verriegelungselement 11 in der dargestellten Verriegelungsposition nicht oder nur unwesentlich aus der Kontur des Isolierstoffmantels 14 heraussteht. Eine Manipulation des Blechstreifens von Außen ist damit nahezu unmöglich. Das Verriegelungselement 11 ist durch formschlüssiges Umschließen des Blechstreifens durch den Isolierstoffmantel 14 an dem Ende, das der Rastlasche 29 gegenüberliegt, festgelegt.

Figur 13 lässt den Überbrückungsstecker 4 aus Figur 12 im Entriegelungszustand der als Blechstreifen ausgeführten Verriegelungselemente 11 erkennen. Deutlich wird, dass das freie, mit der jeweiligen Rastlasche 29 versehene Ende der Blechlaschen nunmehr in die Ausnehmung 21 zurückgefedert ist. Das freie Ende der Verriegelungselemente 11 (Blechlaschen) ist dabei nach Außen von dem gegenüberliegenden Verriegelungselement 11 wegweisend umgebogen (Biegeabschnitt 30). Damit wird eine Einführungsschräge bereitgestellt, die beim Aufstecken des Überbrückungssteckers 4 auf einen Anschlussklemmenblock 3 die Verlagerung des Verriegelungsabschnitts in die dargestellte Ent-riegelungsposition bewirkt.

Erkennbar ist aus den Figuren 12 und 13, dass der Blechstreifen, d. h. das Verriegelungselement 11, sowohl in der Verriegelungs- als auch in der Entriegel-ungsposition front- und rückseitig mit Hilfe der Ausnehmung 21 durch den Isolierstoffmantel 24 abgedeckt und somit eine Manipulation des Blechstreifens von Außen insbesondere dann nahezu unmöglich wird, wenn der Überbrückungsstecker 4 auf einem Anschlussklemmenblock 3 aufgesetzt ist und das Verriegelungselement 11 in der Verriegelungsposition ist. Durch den unten angrenzenden Anschlussklemmenblock 3 und die front- und stirnseitige Abdeckung durch den Isolierstoffmantel 14 ist der Blechstreifen nicht oder nur extrem schwer zugänglich und kann dann nicht in die Entriegelungsposition gebracht werden. Dies gelingt nur durch Aufstecken eines Elektrizitätszählers 2, dessen Führungszapfen 6 dann die Rastlaschen 29 der Verriegelungselementes 11 beaufschlagen und die federelastischen Blechstreifen hierdurch in die Entriegelungsposition biegen.

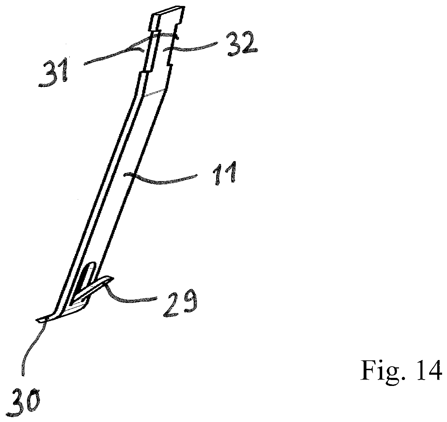

Figur 14 lässt eine perspektivische Ansicht des Verriegelungselementes 11 für die zweite Ausführungsform des Überbrückungssteckers 4 aus Figuren 12 und 13 in Form eines Blechstreifens erkennen. Deutlich wird, dass aus der Ebene des Verriegelungselementes 11 (Blechstreifens) eine Rastlasche 29 herausgebogen ist. Diese Rastlasche 29 ist einstückig aus dem Blechstreifen durch Freilegen (Freischneiden oder Freistanzen) und Herausbiegen geformt. Zur Bereitstellung einer Auflaufschräge ist das freie Ende des Blechstreifens 11 angrenzend an die Rastlasche 29 unter Bildung eines Biegeabschnitts 30 umgebogen.

An der Seite, die der Rastlasche 29 gegenüberliegt, Seite ist durch zwei gegenüberliegende Einschnitte 31 ein schmaler Stegabschnitt 32 ausgeformt. Dieser Stegabschnitt 32 dient zum Fixieren des Verriegelungselementes 11 in dem Isolierstoffmantel 14 derart, dass der Isolierstoffmantel 14 in einer durch die Einschnitte 31 bereitgestellten Freiraum eintaucht. Damit wird das Verriegelungselement 11 am Isolierstoffmantel 14 lagefixiert.

Der Blechstreifen besteht vorzugweise aus einer federelastischen Metalllegierung. Der Blechstreifen kann aber auch aus einem anderen federelastischen Material, wie beispielsweise einem Faserverbundmaterial gebildet werden. Unter einem "Blechstreifen" wird somit nicht nur ein Metallblech verstanden.

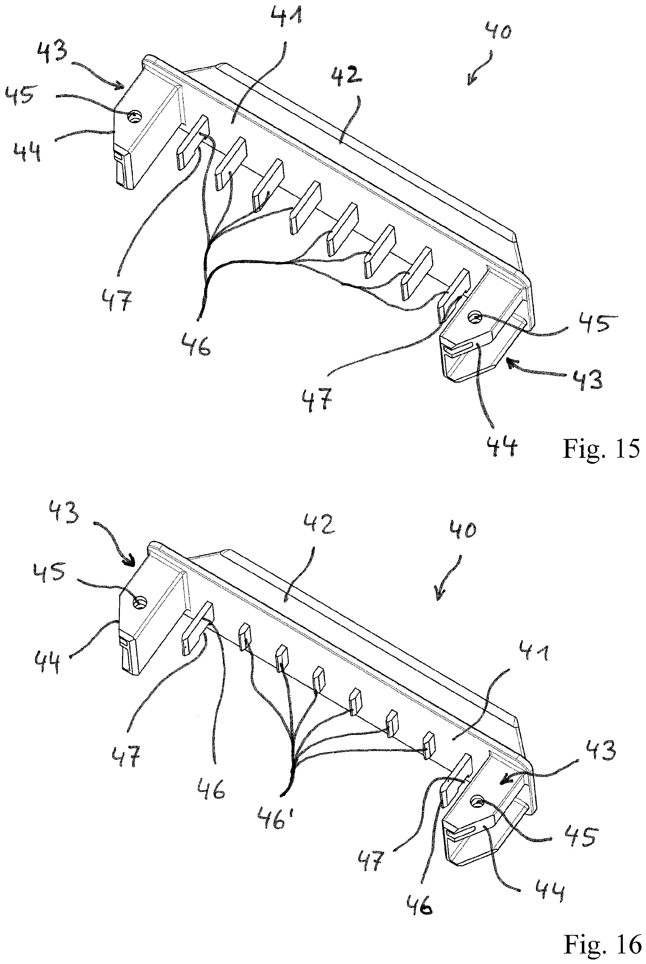

Figur 15 zeigt eine erste Ausführungsform eines Blindsteckers 40 in perspektivischer Ansicht. Der Blindstecker 40 hat eine Frontblende 41 aus elektrisch isolierendem Material, z.B. Kunststoff, mit einer Griffleiste 42. An den beiden äußeren Endbereichen der Frontblende 41 erstrecken sich gegenüberliegend zur Griffleiste 42 zwei Führungszapfen 43. Diese sind diametral gegenüberliegend voneinander angeordnet und haben dieselbe Kontur wie die Führungszapfen 6 des Elektrizitätszählers 2. Die Führungszapfen 43 bilden jeweils einen Abschnitt, der in den durch die Verriegelungslaschen 12 begrenzten Freiraum des Anschlussklemmenblocks 3 eintaucht, wenn der Blindstecker 40 auf den Anschlussklemmenblock 3 aufgesteckt wird. Dann wird, genau so wie beim Aufstecken des Elektrizitätszählers, ein ggf. aufgesteckter Überbrückungsstecker 4 entriegelt. Hierzu haben die Führungszapfen 43 ebenfalls schräge Führungsflächen 44.

Weiterhin sind, wie auch bei den Führungszapfen 6 der Elektrizitätszähler 2, Verplombungs-Öffnungen 45 zumindest in den oberen Stegen, die im eingesteckten Zustand an die Verriegelungslaschen 12 des Anschlussklemmenblocks 3 angrenzen, eingebracht. Dies ermöglicht die manipulationssicher Verplombung des Blindsteckers 40 an dem Anschlussklemmenblock 3 durch Hindurchfädeln eines Verplombungsdrahtes und Verplombung desselben. Die Verplombungs-Öffnungen 45 können in einem Ausführungsbeispiel einen Metalleinsatz mit oder ohne Innengewinde haben. Die Verplombung kann dann z.B. mit Hilfe einer in die Verplombungs-Öffnungen 45 jeweils hineingeführten Schraube erfolgen.

Deutlich wird weiterhin, dass in dem Ausführungsbeispiel aus Figur 15 eine Anzahl von Führungselementen 46 in einer Anreihrichtung nebeneinander und parallel zueinander aus der Frontblende 41 auf der Seite, die der Griffleiste 42 gegenüberliegt, herausragen. Diese Führungselemente 46 entsprechen in ihrer Form und Länge den Anschlusskontakten eines Elektrizitätszählers 2, haben aber keine elektrische Funktion. Sie sind nicht elektrisch leitend miteinander verbunden. Sie können aus einem elektrisch leitfähigen Material, z.B. als Metallblech-Messerkontakt, ausgeführt sein. Denkbar ist aber auch die Ausführung als elektrischer Nichtleiter, z.B. integral mit der Frontblende 41 aus Kunststoffmaterial ggf. mit Faserverstärkung hergestellt.

Erkennbar ist, dass die beiden äußeren Führungselemente 46 Rastkonturen 47 in Form von Einschnitten oder Buchten haben. Damit wird der Blindstecker 40 im auf den Anschlussklemmenblock 3 aufgesteckten Zustand mit Hilfe der in die Rastkonturen 47 eingreifenden Elektrizitätszähler-Anschlussklemmen des Anschlussklemmenblocks 3 verrastet. Die mit Rastkonturen versehenen Führungselemente 46 wirken dabei vorzugsweise mit den Elektrizitätszähler-Anschlussklemmen zusammen, die mit einem Nullleiter oder Masseanschluss der Energieversorgung verbunden sind.

Figur 16 zeigt eine zweite Ausführungsform des Blindsteckers 40. Dieser ist im Hinblick auf die Griffleiste 42 und die Führungselemente 46 vergleichbar zum ersten Ausführungsbeispiel ausgebildet, so dass auf das oben Gesagte verwiesen werden kann.

Bei diesem Ausführungsbeispiel sind zwei unterschiedlich lange Arten von Führungselementen 46 vorgesehen. Die beiden äußeren Führungselemente 46, welche die Rastkonturen 47 aufweisen, haben eine zur Verrastung an den Elektrizitätszähler-Anschlussklemmen des Anschlussklemmenblocks ausreichende Länge. Die dazwischen liegenden Führungselemente 46' sind hingegen wesentlich kürzer ausgeführt, so dass diese zwar noch in die zu den Elektrizitätszähler-Anschlussklemmen führenden Einführöffnungen des Anschlussklemmenblocks 3 hineintauchen, dabei jedoch nicht mit den Elektrizitätszähler-Anschlussklemmen in Kontakt treten. Hierdurch wird sichergestellt, dass der Blindstecker 40 nicht mit elektrischem Spannungspotential in Kontakt tritt.

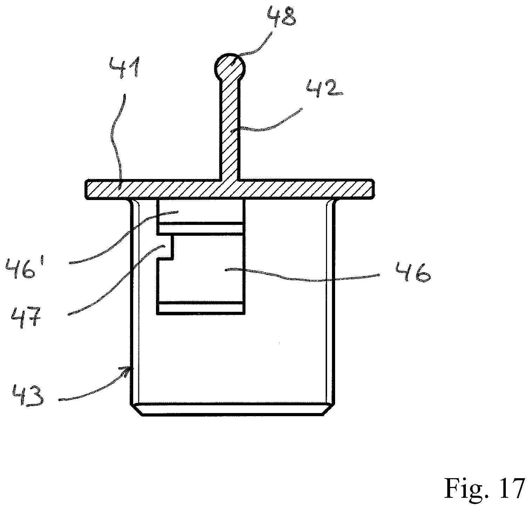

Figur 17 lässt eine Seiten-Schnittansicht des Blindsteckers 40 aus Figur 16 erkennen. Deutlich wird, dass das sichtbare äußere Führungselement 46 eine mehr als 3-fache Länge als die dazwischen liegenden kürzeren Führungselemente 46' hat. Erkennbar ist auch, dass die längeren Führungselemente 46 eine Rastkontur 47 an einer Seitenkante in Form eines rechteckförmigen Ausschnitts (Bucht) hat. Erkennbar ist weiterhin, dass der Griffsteg 42 an seinem freien Ende eine Griffwulst 48 aufweist.

## Patentansprüche

1. Elektrizitätszähler-Anschlusssystem (1) mit einem Elektrizitätszähler (2), einem Anschlussklemmenblock (3), der ein Isolierstoffgehäuse (9), Leiteranschlüsse zum Anschluss elektrischer Leitungen und Elektrizitätszähler-Anschlussklemmen zur elektrisch leitenden Verbindung von Leiteranschlüssen mit zugeordneten Anschlusskontakten (5) des an dem Anschlussklemmenblock (3) angeordneten Elektrizitätszählers (2) hat, und mit einem Überbrückungsstecker (4) zum Aufstecken auf den Anschlussklemmenblock (3), wobei der Überbrückungsstecker (4) Überbrückungskontakte (35) zur elektrisch leitenden Verbindung mit zugeordneten Leiteranschlüssen und Elektrizitätszähler-Anschlussklemmen des zugeordneten Anschlussklemmenblocks (3) hat, **dadurch gekennzeichnet, dass** der Überbrückungsstecker (4) mindestens ein Verriegelungselement (11) hat, das eine zur Verriegelung an dem Anschlussklemmenblock im auf den Anschlussklemmenblock (3) aufgesetzten Zustand ausgebildete Verriegelungskontur hat und dass das mindestens eine Verriegelungselement (11) derart angeordnet ist, dass ein Abschnitt des auf den Anschlussklemmenblock (3) aufgesteckten Elektrizitätszählers (2) mit dem Verriegelungselement (11) zum Aufheben oder Verhindern einer Verriegelung des Verriegelungselementes (11) an dem Anschlussklemmenblock (3) zusammenwirkt.

2. Elektrizitätszähler-Anschlusssystem (1) nach Anspruch 1, **dadurch gekennzeichnet, dass** zwei federelastische oder federelastisch gelagerte Verriegelungshebel (11) diametral gegenüberliegend an dem Überbrückungsstecker (4) angeordnet sind, wobei die Verriegelungshebel (11) jeweils eine Rastkontur (17, 29) zur Verrastung mit dem Anschlussklemmenblock (3) hat.

3. Elektrizitätszähler-Anschlusssystem (1) nach Anspruch 2, **dadurch gekennzeichnet, dass** die Verriegelungshebel (11) als schwenkbar an dem Überbrückungsstecker (4) gelagerte, starre Hebelarme mit jeweils einer vorspringenden Rastnase (17) ausgeführt sind und zwischen Hebelarm und einem Isolierstoffmantel (14) des Überbrückungssteckers (4) ein Federelement (20) zur federelastischen Verlagerung des Hebelarms in die Verriegelungsposition ausgeführt sind.

4. Elektrizitätszähler-Anschlusssystem (1) nach Anspruch 2, **dadurch gekennzeichnet, dass** die Verriegelungshebel (11) als federelastisch biegsamer Blechstreifen mit einer aus der Ebene des Blechsstreifens vorspringender Rastlasche (29) am freien Ende ausgebildet sind.

5. Elektrizitätszähler-Anschlusssystem (1) nach Anspruch 4, **dadurch gekennzeichnet, dass** die Blechstreifen in einem Isolierstoffmantel (14) des Überbrückungssteckers (4) festgelegt sind.

6. Elektrizitätszähler-Anschlusssystem (1) nach einem der Ansprüche 3 bis 5, **dadurch gekennzeichnet, dass** die Rastnasen (17) oder Rastlaschen (29) einstückig aus dem Verriegelungselement (11) gebildet sind.

7. Elektrizitätszähler-Anschlusssystem (1) nach einem der Ansprüche 2 bis 6, **dadurch gekennzeichnet, dass** die Rastkonturen (17, 29) und/oder der Elektrizitätszähler (2) eine schräge Führungsfläche (13, 18) haben, die ausgerichtet ist, um eine Verlagerung des zugeordneten Verriegelungshebels (11) aus einer Verriegelungsposition in eine Entriegelungsposition bei Aufstecken des Elektrizitätszählers (2) auf den Anschlussklemmenblock (3) durch Führung eines Abschnitts des Elektrizitätszählers (2) an der zugeordneten Rastkontur (17, 29) mittels der Führungsfläche (13, 18) zu bewirken.

8. Elektrizitätszähler-Anschlusssystem (1) nach einem der vorhergehenden Ansprüche, **dadurch gekennzeichnet, dass** der Überbrückungsstecker (4) einen federbelasteten Berührungsschutzrahmen (24) hat, der die Überbrückungskontakte (35) umgibt und in Erstreckungsrichtung der Überbrückungskontakte (35) beweglich an einem Isolierstoffmantel (14) des Überbrückungssteckers (4) gelagert ist, wobei zwischen dem Isolierstoffmantel (14) und dem Berührungsschutzrahmen (24) mindestens ein Federelement (28) angeordnet ist, das die Verlagerung des Berührungsschutzrahmens (24) in einen die aus dem Isolierstoffmantel (14) herausragenden Abschnitte der Überbrückungskontakte (35) mindestens teilweise abdeckenden Zustand bewirkt.

9. Elektrizitätszähler-Anschlusssystem (1) nach Anspruch 8, **dadurch gekennzeichnet, dass** der Berührungsschutzrahmen (24) in einer Ausnehmung des Isolierstoffmantels (14) des Überbrückungssteckers (4) beweglich gelagert ist.

10. Elektrizitätszähler-Anschlusssystem (1) nach Anspruch 8 oder 9, **dadurch gekennzeichnet, dass** die Überbrückungskontakte (35) U-förmig gebogen sind und zwei über einen gemeinsamen Bogenabschnitt (23) miteinander verbundene, parallele Steckkontaktabschnitte (22) haben, die aus dem Isolierstoffmantel (14) herausragen, wobei der Bogenabschnitt (23) im Isolierstoffmantel (14) festgelegt ist, und dass das mindestens eine zwischen Isolierstoffmantel (14) und Berührungsschutzrahmen (24) angeordnete Federelement (28) in einem durch den U-förmig gebogenen Überbrückungskontakt (35) begrenzten Innenraum gelagert ist.

11. Elektrizitätszähler-Anschlusssystem (1) nach Anspruch 10, **dadurch gekennzeichnet, dass** zwei diametral gegenüberliegende Federelemente (28) vorgesehen sind, die jeweils im Innenraum des U-förmig gebogenen Überbrückungskontakt (35) der äußeren Überbrückungskontakte (25) angeordnet sind.

12. Elektrizitätszähler-Anschlusssystem (1) nach einem der vorhergehenden Ansprüche, **gekennzeichnet durch** einen Blindstecker (40), der zum Aufstecken auf den Anschlussklemmenblock (3) an Stelle eines Energiezählers (2) vorgesehen ist und mindestens einen Abschnitt, vorzugsweise in Form von diametral gegenüberliegenden Führungszapfen (43), hat, der ausgebildet ist, um im aufgesteckten Zustand des Blindsteckers (40) auf den Anschlussklemmenblock (3) mit dem Verriegelungselement (11) zum Aufheben oder Verhindern einer Verriegelung des Verriegelungselementes (11) an dem Anschlussklemmenblock (3) zusammenzuwirken.

13. Elektrizitätszähler-Anschlusssystem (1) nach Anspruch 12, **dadurch gekennzeichnet, dass** der Blindstecker (40) Führungselemente (46, 46') hat, die korrespondierend mit Anschlusskontakten (5) des Elektrizitätszählers (2) zur Einführung in zu Elektrizitätszähler-Anschlussklemmen führende Einführungsöffnungen des Anschlussklemmenblocks (3) ausgebildet sind.

14. Elektrizitätszähler-Anschlusssystem (1) nach Anspruch 13, **dadurch gekennzeichnet, dass** mindestens eines der Führungselemente (46, 46') eine Rastkontur zur Verrastung des Blindsteckers (40) an dem Anschlussklemmenblock (3) hat.

15. Überbrückungsstecker (4) für ein Elektrizitätszähler-Anschlusssystem (1) nach einem der vorhergehenden Ansprüche, mit einem Isolierstoffmantel (14), wobei der Überbrückungsstecker (4) mindestens ein Verriegelungselement (11) hat, das eine zur Verriegelung an einem Anschlussklemmenblock (3) im auf den Anschlussklemmenblock (3) aufgesetzten Zustand ausgebildete Verriegelungskontur (17, 29) aufweist, **dadurch gekennzeichnet, dass** zwei federelastische oder federelastisch gelagerte Verriegelungshebel (11) diametral gegenüberliegend an dem Überbrückungsstecker (4) angeordnet und in einer geeignet konturierten Ausnehmung (21) des Isolierstoffmantels (14) gelagert sind, wobei die Verriegelungshebel (11) jeweils eine Rastkontur (17, 29) zur Verrastung mit einem zugeordneten Anschlussklemmenblock (3) haben und dass das Verriegelungselement (11) derart angeordnet ist, dass ein Abschnitt eines auf den Anschlussklemmenblock (3) aufgesteckten Elektrizitätszählers (2) mit dem Verriegelungselement (11) zum Aufheben oder Verhindern einer Verriegelung des Verriegelungselementes (11) an dem Anschlussklemmenblock (3) zusammenwirkt.

16. Überbrückungsstecker (4) nach Anspruch 15, **dadurch gekennzeichnet, dass** der Überbrückungsstecker (4) einen federbelasteten Berührungsschutzrahmen (24) hat, der die Überbrückungskontakte (35) umgibt und in Erstreckungsrichtung der Überbrückungskontakte (35) beweglich an einem Isolierstoffmantel (14) des Überbrückungssteckers (4) gelagert ist, wobei zwischen dem Isolierstoffmantel (14) und dem Berührungsschutzrahmen (24) mindestens ein Federelement angeordnet ist, dass die Verlagerung des Berührungsschutzrahmens (24) in einen die aus dem Isolierstoffmantel (14) herausragenden Abschnitte der Überbrückungskontakte (35) mindestens teilweise abdeckenden Zustand bewirkt.

17. Überbrückungsstecker (4) nach einem der Ansprüche 15 oder 16, **dadurch gekennzeichnet, dass** die Verriegelungshebel (11) als schwenkbar in dem Überbrückungsstecker (4) gelagerte, starre Hebelarme mit jeweils einer vorspringenden Rastnase (17) ausgeführt sind und zwischen Hebelarm und Isolierstoffmantel (14) des Überbrückungssteckers (4) ein Federelement (20) zur federelastischen Verlagerung des Hebelarms in die Verriegelungsposition ausgeführt sind.

18. Überbrückungsstecker (4) nach einem der Ansprüche 15 bis 17, **dadurch gekennzeichnet, dass** die Verriegelungshebel (11) als federelastisch biegsame Blechstreifen mit einer aus der Ebene des Blechstreifens vorspringenden Rastlasche (29) am freien Ende ausgebildet sind.

19. Überbrückungsstecker (4) nach einem der Ansprüche 15 bis 18, **dadurch gekennzeichnet, dass** die Überbrückungskontakte (35) U-förmig gebogen sind und zwei über einen gemeinsamen Bogenabschnitt (23) miteinander verbundene, parallele Steckkontaktabschnitte (22) haben, die aus dem Isolierstoffmantel (14) herausragen, wobei der Bogenabschnitt (23) in dem Isolierstoffmantel (14) festgelegt ist und wobei das mindestens eine zwischen Isolierstoffmantel (14) und Berührungsschutzrahmen (24) angeordnete Federelement (28) in jeweils einem durch einen der U-förmig gebogenen Überbrückungskontakte (35) begrenzten Innenraum gelagert ist.

20. Blindstecker (40) für ein Elektrizitätszähler-Anschlusssystem (1) nach einem der Ansprüche 1 bis 11, **dadurch gekennzeichnet, dass** der Blindstrecker (40) zum Aufstecken auf den Anschlussklemmenblock (3) an Stelle eines Energiezählers (2) vorgesehen ist und mindestens einen Abschnitt, vorzugsweise in Form von diametral gegenüberliegenden Führungszapfen (43), hat, der ausgebildet ist, um im aufgesteckten Zustand des Blindsteckers (40) auf den Anschlussklemmenblock (3) mit dem Verriegelungselement (11) zum Aufheben oder Verhindern einer Verriegelung des Verriegelungselementes (11) an dem Anschlussklemmenblock (3) zusammenzuwirken.

21. Blindstecker (40) nach Anspruch 20, **dadurch gekennzeichnet, dass** der Blindstecker (40) Führungselemente (46, 46') hat, die korrespondierend mit Anschlusskontakten (5) des Elektrizitätszählers (2) zur Einführung in zu Elektrizitätszähler-Anschlussklemmen führende Einführungsöffnungen des Anschlussklemmenblocks (3) ausgebildet sind.

22. Blindstecker (40) nach Anspruch 21, **dadurch gekennzeichnet, dass** mindestens eines der Führungselemente (46, 46') eine Rastkontur zur Verrastung des Blindsteckers (40) an dem Anschlussklemmenblock (3) hat

## Claims

1. Electricity meter connection system (1) comprising an electricity meter (2), a connection terminal block (3) which has an insulating-material housing (9), conductor connections for connecting electrical lines and electricity meter connection terminals for electrically conductively connecting conductor connections to associated connection contacts (5) of the electricity meter (2) which is arranged on the connection terminal block (3), and comprising a bridging plug (4) for fitting onto the connection terminal block (3), wherein the bridging plug (4) has bridging contacts (35) for electrically conductive connection to associated conductor connections and electricity meter connection terminals of the associated connection terminal block (3), **characterized in that** the bridging plug (4) has at least one locking element (11) which has a locking contour which is designed for locking to the connection terminal block in the state in which it is fitted onto the connection terminal block (3) and **in that** the at least one locking element (11) is arranged in such a way that a section of the electricity meter (2), which is fitted onto the connection terminal block (3), interacts with the locking element (11) for cancelling or preventing locking of the locking element (11) to the connection terminal block (3).

2. Electricity meter connection system (1) according to Claim 1, **characterized in that** two spring-elastic or spring-elastically mounted locking levers (11) are arranged diametrically opposite one another on the bridging plug (4), wherein the locking levers (11) each have a latching contour (17, 29) for latching to the connection terminal block (3).

3. Electricity meter connection system (1) according to Claim 2, **characterized in that** the locking levers (11) are designed as rigid lever arms which are pivotably mounted on the bridging plug (4) and each have a projecting latching lug (17), and a spring element (20) for spring-elastically moving the lever arm into the locking position is designed between the lever arm and an insulating-material casing (14) of the bridging plug (4) .

4. Electricity meter connection system (1) according to Claim 2, **characterized in that** the locking levers (11) are designed as spring-elastically flexible sheet-metal strips with a latching tab (29), which projects out of the plane of the sheet-metal strip, at the free end.

5. Electricity meter connection system (1) according to Claim 4, **characterized in that** the sheet-metal strips are fixed in an insulating-material casing (14) of the bridging plug (4).

6. Electricity meter connection system (1) according to one of Claims 3 to 5, **characterized in that** the latching lugs (17) or latching tabs (29) are integrally formed from the locking element (11).

7. Electricity meter connection system (1) according to one of Claims 2 to 6, **characterized in that** the latching contours (17, 29) and/or the electricity meter (2) have/has an oblique guide surface (13, 18) which is oriented in order to cause movement of the associated locking lever (11) out of a locking position into a unlocking position when the electricity meter (2) is fitted onto the connection terminal block (3) by guiding a section of the electricity meter (2) on the associated latching contour (17, 29) by means of the guide surface (13, 18).

8. Electricity meter connection system (1) according to one of the preceding claims, **characterized in that** the bridging plug (4) has a spring-loaded direct-contact protection frame (24) which surrounds the bridging contacts (35) and is mounted on an insulating-material casing (14) of the bridging plug (4) such that it can move in the direction of extent of the bridging contacts (35), wherein at least one spring element (28) is arranged between the insulating-material casing (14) and the direct-contact protection frame (24), which spring element causes the movement of the direct-contact protection frame (24) into a state which at least partially covers those sections of the bridging contacts (35) which protrude out of the insulating-material casing (14) .

9. Electricity meter connection system (1) according to Claim 8, **characterized in that** the direct-contact protection frame (24) is movably mounted in a recess of the insulating-material casing (14) of the bridging plug (4) .

10. Electricity meter connection system (1) according to Claim 8 or 9, **characterized in that** the bridging contacts (35) are bent in a U shape and have two parallel plug-in contact sections (22) which are connected to one another by means of a common bent section (23) and which protrude out of the insulating-material casing (14), wherein the bent section (23) is fixed in the insulating-material casing (14), and **in that** the at least one spring element (28) which is arranged between the insulating-material casing (14) and the direct-contact protection frame (24) is mounted in an interior space which is delimited by the bridging contact (35) which is bent in a U shape.

11. Electricity meter connection system (1) according to Claim 10, **characterized in that** two diametrically opposite spring elements (28) are provided, which are each arranged in the interior space of the bridging contact (35) of the outer bridging contacts (25) which is bent in a U shape.

12. Electricity meter connection system (1) according to one of the preceding claims, **characterized by** a dummy plug (40) which is provided for fitting onto the connection terminal block (3) instead of an energy meter (2) and has at least one section, preferably in the form of diametrically opposite guide pins (43), which is designed in order to interact with the locking element (11) in the state in which the dummy plug (40) is fitted onto the connection terminal block (3), for cancelling or preventing locking of the locking element (11) to the connection terminal block (3).

13. Electricity meter connection system (1) according to Claim 12, **characterized in that** the dummy plug (40) has guide elements (46, 46') which are designed in a manner corresponding to connection contacts (5) of the electricity meter (2) for insertion into insertion openings of the connection terminal block (3) which lead to electricity meter connection terminals.

14. Electricity meter connection system (1) according to Claim 13, **characterized in that** at least one of the guide elements (46, 46') has a latching contour for latching the dummy plug (40) to the connection terminal block (3).

15. Bridging plug (4) for an electricity meter connection system (1) according to one of the preceding claims, comprising an insulating-material casing (14), wherein the bridging plug (4) has at least one locking element (11) which has a locking contour (17, 29) which is designed for locking to a connection terminal block (3) in the state in which it is fitted onto the connection terminal block (3), **characterized in that** two spring-elastic or spring-elastically mounted locking levers (11) are arranged diametrically opposite one another on the bridging plug (4) and mounted in a suitably contoured recess (21) of the insulating-material casing (14), wherein the locking levers (11) each have a latching contour (17, 29) for latching to an associated connection terminal block (3), and **in that** the locking element (11) is arranged in such a way that a section of an electricity meter (2), which is fitted onto the connection terminal block (3), interacts with the locking element (11) for cancelling or preventing locking of the locking element (11) to the connection terminal block (3).

16. Bridging plug (4) according to Claim 15, **characterized in that** the bridging plug (4) has a spring-loaded direct-contact protection frame (24) which surrounds the bridging contacts (35) and is mounted on an insulating-material casing (14) of the bridging plug (4) such that it can move in the direction of extent of the bridging contacts (35), wherein at least one spring element is arranged between the insulating-material casing (14) and the direct-contact protection frame (24), which spring element causes the movement of the direct-contact protection frame (24) into a state which at least partially covers those sections of the bridging contacts (35) which protrude out of the insulating-material casing (14) .

17. Bridging plug (4) according to either of Claims 15 and 16, **characterized in that** the locking levers (11) are designed as rigid lever arms which are pivotably mounted in the bridging plug (4) and each have a projecting latching lug (17), and a spring element (20) for spring-elastically moving the lever arm into the locking position is designed between the lever arm and the insulating-material casing (14) of the bridging plug (4).

18. Bridging plug (4) according to one of Claims 15 to 17, **characterized in that** the locking levers (11) are designed as spring-elastically flexible sheet-metal strips with a latching tab (29), which projects out of the plane of the sheet-metal strip, at the free end.

19. Bridging plug (4) according to one of Claims 15 to 18, **characterized in that** the bridging contacts (35) are bent in a U shape and have two parallel plug-in contact sections (22) which are connected to one another by means of a common bent section (23) and which protrude out of the insulating-material casing (14), wherein the bent section (23) is fixed in the insulating-material casing (14), and wherein the at least one spring element (28) which is arranged between the insulating-material casing (14) and the direct-contact protection frame (24) is mounted in a respective interior space which is delimited by one of the bridging contacts (35) which is bent in a U shape.

20. Dummy plug (40) for an electricity meter connection system (1) according to one of Claims 1 to 11, **characterized in that** the dummy plug (40) is provided for fitting onto the connection terminal block (3) instead of an energy meter (2) and has at least one section, preferably in the form of diametrically opposite guide pins (43), which is designed in order to interact with the locking element (11) in the state in which the dummy plug (40) is fitted onto the connection terminal block (3), for cancelling or preventing locking of the locking element (11) to the connection terminal block (3).

21. Dummy plug (40) according to Claim 20, **characterized in that** the dummy plug (40) has guide elements (46, 46') which are designed in a manner corresponding to connection contacts (5) of the electricity meter (2) for insertion into insertion openings of the connection terminal block (3) which lead to electricity meter connection terminals.

22. Dummy plug (40) according to Claim 21, **characterized in that** at least one of the guide elements (46, 46') has a latching contour for latching the dummy plug (40) to the connection terminal block (3).

## Revendications

1. Système de raccordement de compteur d'électricité (1), comprenant un compteur d'électricité (2), un bornier de raccordement (3), qui comporte un boîtier en matériau isolant (9), des raccords de conducteur destinés au raccordement de lignes électriques et des bornes de raccordement de compteur d'électricité destinées à la liaison électriquement conductrice des raccords de conducteur avec des contacts de raccordement (5) associés du compteur d'électricité (2) disposé au niveau du bornier de raccordement (3), et comprenant une fiche de pontage (4) destinée à être enfichée sur le bornier de raccordement (3), la fiche de pontage (4) comportant des contacts de pontage (35) destinés à la liaison électriquement conductrice avec les raccords de conducteur et les bornes de raccordement de compteur d'électricité associés du bornier de raccordement (3) associé, **caractérisé en ce que** la fiche de pontage (4) comporte au moins un élément de verrouillage (11), qui comporte un contour de verrouillage configuré pour être verrouillé au bornier de raccordement dans l'état monté sur le bornier de raccordement (3) et **en ce que** l'au moins un élément de verrouillage (11) est disposé de telle sorte qu'une portion du compteur d'électricité (2) enfiché sur le bornier de raccordement (3) coopère avec l'élément de verrouillage (11) pour annuler ou empêcher un verrouillage de l'élément de verrouillage (11) au bornier de raccordement (3).

2. Système de raccordement de compteur d'électricité (1) selon la revendication 1, **caractérisé en ce que** deux leviers de verrouillage (11) à flexibilité de ressort, ou supportés avec flexibilité de ressort, sont disposés diamétralement de manière opposée sur la fiche de pontage (4), les leviers de verrouillage (11) comportant respectivement un contour d'encliquetage (17, 29) destiné à s'encliqueter avec le bornier de raccordement (3).

3. Système de raccordement de compteur d'électricité (1) selon la revendication 2, **caractérisé en ce que** les leviers de verrouillage (11) sont réalisés sous la forme de bras de levier rigides montés pivotants sur la fiche de pontage (4), chacun comportant un taquet d'encliquetage (17) en saillie, et un élément ressort (20) destiné à déplacer le bras de levier avec flexibilité de ressort dans la position de verrouillage est réalisé entre le bras de levier et une enveloppe en matériau isolant (14) de la fiche de pontage (4).

4. Système de raccordement de compteur d'électricité (1) selon la revendication 2, **caractérisé en ce que** les leviers de verrouillage (11) sont réalisés sous la forme de bandes de tôle flexibles avec flexibilité de ressort munies, au niveau de l'extrémité libre, d'une languette d'encliquetage (29) en saillie depuis le plan de la bande de tôle.

5. Système de raccordement de compteur d'électricité (1) selon la revendication 4, **caractérisé en ce que** les bandes de tôle sont fixées dans une enveloppe en matériau isolant (14) de la fiche de pontage (4) .

6. Système de raccordement de compteur d'électricité (1) selon l'une des revendications 3 à 5, **caractérisé en ce que** les taquets d'encliquetage (17) ou les languettes d'encliquetage (29) sont formés d'un seul tenant depuis l'élément de verrouillage (11).

7. Système de raccordement de compteur d'électricité (1) selon l'une des revendications 2 à 6, **caractérisé en ce que** les contours d'encliquetage (17, 29) et/ou le compteur d'électricité (2) comportent une surface de guidage (13, 18) en biais, laquelle est orientée pour provoquer un déplacement du levier de verrouillage (11) associé depuis une position de verrouillage dans une position de déverrouillage lors de l'enfichage du compteur d'électricité (2) sur le bornier de raccordement (3) par guidage d'une portion du compteur d'électricité (2) au niveau du contour d'encliquetage (17, 29) associé au moyen de la surface de guidage (13, 18) .

8. Système de raccordement de compteur d'électricité (1) selon l'une des revendications précédentes, **caractérisé en ce que** la fiche de pontage (4) comporte un cadre de protection contre le contact (24) chargé par ressort, lequel entoure les contacts de pontage (35) et est monté sur une enveloppe en matériau isolant (14) de la fiche de pontage (4) avec mobilité dans le sens de la projection des contacts de pontage (35), au moins un élément ressort (28) étant disposé entre l'enveloppe en matériau isolant (14) et le cadre de protection contre le contact (24), lequel provoque le déplacement du cadre de protection contre le contact (24) dans un état de recouvrement au moins partiel des portions des contacts de pontage (35) qui font saillie hors de l'enveloppe en matériau isolant (14).

9. Système de raccordement de compteur d'électricité (1) selon la revendication 8, **caractérisé en ce que** le cadre de protection contre le contact (24) est monté mobile dans une cavité de l'enveloppe en matériau isolant (14) de la fiche de pontage (4).

10. Système de raccordement de compteur d'électricité (1) selon la revendication 8 ou 9, **caractérisé en ce que** les contacts de pontage (35) sont cintrés en forme de U et comportent deux portions de contact à enficher (22) parallèles, reliées entre elles par le biais d'une portion cintrée (23) commune, lesquelles font saillie hors de l'enveloppe en matériau isolant (14), la portion cintrée (23) étant fixée dans l'enveloppe en matériau isolant (14), et **en ce que** l'au moins un élément ressort (28) disposé entre l'enveloppe en matériau isolant (14) et le cadre de protection contre le contact (24) est monté dans un espace intérieur délimité par le contact de pontage (35) cintré en forme de U.

11. Système de raccordement de compteur d'électricité (1) selon la revendication 10, **caractérisé en ce que** deux éléments ressorts (28) diamétralement opposés sont présents, lesquels sont respectivement disposés dans l'espace intérieur du contact de pontage (35) cintré en forme de U des contacts de pontage (25) extérieurs.

12. Système de raccordement de compteur d'électricité (1) selon l'une des revendications précédentes, **caractérisé par** une fiche borgne (40) qui est conçue pour être enfichée sur le bornier de raccordement (3) à la place d'un compteur d'énergie (2) et comporte au moins une portion, de préférence sous la forme de tenons de guidage (43) diamétralement opposés, laquelle est configurée pour, dans l'état enfiché de la fiche borgne (40) sur le bornier de raccordement (3), coopérer avec l'élément de verrouillage (11) pour annuler ou empêcher un verrouillage de l'élément de verrouillage (11) au bornier de raccordement (3).

13. Système de raccordement de compteur d'électricité (1) selon la revendication 12, **caractérisé en ce que** la fiche borgne (40) comporte des éléments de guidage (46, 46') qui sont configurés en correspondance avec des contacts de raccordement (5) du compteur d'électricité (2) en vue d'être introduits dans des ouvertures d'introduction du bornier de raccordement (3) menant vers les bornes de raccordement de compteur d'électricité.

14. Système de raccordement de compteur d'électricité (1) selon la revendication 13, **caractérisé en ce qu'**au moins l'un des éléments de guidage (46, 46') comporte un contour d'encliquetage destiné à encliqueter la fiche borgne (40) au bornier de raccordement (3).

15. Fiche de pontage (4) pour un système de raccordement de compteur d'électricité (1) selon l'une des revendications précédentes, comprenant une enveloppe en matériau isolant (14), la fiche de pontage (4) comportant au moins un élément de verrouillage (11), lequel possède un contour de verrouillage (17, 29) configuré pour s'encliqueter à un bornier de raccordement (3) dans l'état monté sur le bornier de raccordement (3), **caractérisée en ce que** deux leviers de verrouillage (11) à flexibilité de ressort, ou supportés avec flexibilité de ressort, sont disposés diamétralement de manière opposée sur la fiche de pontage (4) et sont logés dans une cavité (21) ayant un contour approprié de l'enveloppe en matériau isolant (14), les leviers de verrouillage (11) comportant respectivement un contour d'encliquetage (17, 29) destiné à s'encliqueter avec un bornier de raccordement (3) associé et **en ce que** l'élément de verrouillage (11) est disposé de telle sorte qu'une portion d'un compteur d'électricité (2) enfiché sur le bornier de raccordement (3) coopère avec l'élément de verrouillage (11) pour annuler ou empêcher un verrouillage de l'élément de verrouillage (11) au bornier de raccordement (3).

16. Fiche de pontage (4) selon la revendication 15, **caractérisée en ce que** la fiche de pontage (4) comporte un cadre de protection contre le contact (24) chargé par ressort, lequel entoure les contacts de pontage (35) et est monté sur une enveloppe en matériau isolant (14) de la fiche de pontage (4) avec mobilité dans le sens de la projection des contacts de pontage (35), au moins un élément ressort étant disposé entre l'enveloppe en matériau isolant (14) et le cadre de protection contre le contact (24), lequel provoque le déplacement du cadre de protection contre le contact (24) dans un état de recouvrement au moins partiel des portions des contacts de pontage (35) qui font saillie hors de l'enveloppe en matériau isolant (14).

17. Fiche de pontage (4) selon l'une des revendications 15 ou 16, **caractérisée en ce que** les leviers de verrouillage (11) sont réalisés sous la forme de bras de levier rigides montés pivotants dans la fiche de pontage (4), chacun comportant un taquet d'encliquetage (17) en saillie, et un élément ressort (20) destiné à déplacer le bras de levier avec flexibilité de ressort dans la position de verrouillage est réalisé entre le bras de levier et l'enveloppe en matériau isolant (14) de la fiche de pontage (4).

18. Fiche de pontage (4) selon l'une des revendications 15 à 17, **caractérisée en ce que** les leviers de verrouillage (11) sont réalisés sous la forme de bandes de tôle flexibles avec flexibilité de ressort munies, au niveau de l'extrémité libre, d'une languette d'encliquetage (29) en saillie depuis le plan de la bande de tôle.

19. Fiche de pontage (4) selon l'une des revendications 15 à 18, **caractérisée en ce que** les contacts de pontage (35) sont cintrés en forme de U et comportent deux portions de contact à enficher (22) parallèles, reliées entre elles par le biais d'une portion cintrée (23) commune, lesquelle font saillie hors de l'enveloppe en matériau isolant (14), la portion cintrée (23) étant fixée dans l'enveloppe en matériau isolant (14), et l'au moins un élément ressort (28) disposé entre l'enveloppe en matériau isolant (14) et le cadre de protection contre le contact (24) étant monté respectivement dans un espace intérieur délimité par l'un des contacts de pontage (35) cintrés en forme de U.

20. Fiche borgne (40) pour un système de raccordement de compteur d'électricité (1) selon l'une des revendications 1 à 11, **caractérisée en ce que** la fiche borgne (40) est conçue pour être enfichée sur le bornier de raccordement (3) à la place d'un compteur d'énergie (2) et comporte au moins une portion, de préférence sous la forme de tenons de guidage (43) diamétralement opposés, laquelle est configurée pour, dans l'état enfiché de la fiche borgne (40) sur le bornier de raccordement (3), coopérer avec l'élément de verrouillage (11) pour annuler ou empêcher un verrouillage de l'élément de verrouillage (11) au bornier de raccordement (3) .

21. Fiche borgne (40) selon la revendication 20, **caractérisée en ce que** la fiche borgne (40) comporte des éléments de guidage (46, 46') qui sont configurés en correspondance avec des contacts de raccordement (5) du compteur d'électricité (2) en vue d'être introduits dans des ouvertures d'introduction du bornier de raccordement (3) menant vers les bornes de raccordement de compteur d'électricité.

22. Fiche borgne (40) selon la revendication 21, **caractérisée en ce qu'**au moins l'un des éléments de guidage (46, 46') comporte un contour d'encliquetage destiné à encliqueter la fiche borgne (40) au bornier de raccordement (3).
